# EUROPÄISCHE PATENTSCHRIFT

(11) **EP 4 066 604 B1**
(45) Veröffentlichungstag und Bekanntmachung des Hinweises auf die Patenterteilung: **19.02.2025**
(21) Anmeldenummer: 20812324.0
(22) Anmeldetag: 25.11.2020
(51) Int. Cl.: H05K 7/14, H05K 5/06

(54) **FREQUENZUMRICHTER-BAUREIHE**
FREQUENCY CONVERTER CLASS
CLASSE DE CONVERTISSEURS DE FRÉQUENCE

(30) Priorität: 25.11.2019 DE 102019218206
(43) Veröffentlichungstag der Anmeldung: 05.10.2022
(73) Patentinhaber: Lenze Swiss AG, 8590 Romanshorn (CH)
(72) Erfinder: BURGERMEISTER, Andreas, 8576 Mauren (CH); HEIM, Beat, 9225 Wilen (CH); TANNER, Dieter, 8581 Schocherswil (CH)
(74) Vertreter: Patentanwälte Ruff, Wilhelm, Beier, Dauster & Partner mbB
(86) Internationale Anmeldenummer: PCT/EP2020/083389
(87) Internationale Veröffentlichungsnummer: WO 2021/105227

(56) Entgegenhaltungen:
- WO-A1-2004/026013

## Beschreibung

Die Erfindung betrifft eine Frequenzumrichter-Baureihe mit unterschiedlichen Typen von Frequenzumrichtern.

Die WO 2004/026013 A1 offenbart eine Frequenzumrichter-Baureihe gemäß dem Oberbegriff des Anspruchs 1.

Der Erfindung liegt die Aufgabe zugrunde, eine Frequenzumrichter-Baureihe mit unterschiedlichen Typen von Frequenzumrichtern zur Verfügung zu stellen, die einfach und kostengünstig herstellbar ist und die eine hohe Flexibilität ermöglicht.

Diese Aufgabe wird durch eine Frequenzumrichter-Baureihe gemäss Anspruch 1 gelöst. Weitere Ausführungsbeispiele sind den abhängigen Ansprüchen zu entnehmen.

Die Frequenzumrichter-Baureihe umfasst unterschiedliche Typen von Frequenzumrichtern

Ein erster Typ von Frequenzumrichtern der Frequenzumrichter-Baureihe weist folgende Komponenten auf: eine Leistungselektronik, beispielsweise aufweisend einen dreiphasigen Wechselrichter, ein Trägerelement und ein Gehäuseelement eines ersten Gehäuseelement-Typs, das in Verbindung mit dem Trägerelement ein Gehäuse für die Leistungselektronik bildet.

Ein zweiter Typ von Frequenzumrichtern der Frequenzumrichter-Baureihe weist als Gleichteile zum ersten Typ von Frequenzumrichtern ebenfalls die typgleiche Leistungselektronik und das typgleiche Trägerelement auf. Insoweit gibt es zwischen dem ersten Typ und dem zweiten Typ keine Unterschiede. Der zweite Typ von Frequenzumrichtern der Frequenzumrichter-Baureihe unterscheidet sich vom ersten Typ von Frequenzumrichtern der Frequenzumrichter-Baureihe durch sein Gehäuseelement eines zweiten Gehäuseelement-Typs, das in Verbindung mit dem Trägerelement ein Gehäuse für die Leistungselektronik bildet.

Das Gehäuseelement des ersten Gehäuseelement-Typs ist derart gestaltet, dass der Frequenzumrichter des ersten Typs eine erste Schutzart aufweist. Das Gehäuseelement des zweiten Gehäuseelement-Typs ist derart gestaltet, dass der Frequenzumrichter des zweiten Typs eine zweite, von der ersten Schutzart verschiedene Schutzart aufweist. Der erste Gehäuseelement-Typ kann identische Abmessungen aufweisen wie der zweite Gehäuseelement-Typ, also eine identische Länge, Breite, Höhe usw.

Gemäß einer Ausführungsform ist die erste Schutzart IP 66 gemäß IEC 60 529 (EN 60 529). Hierzu kann das Gehäuseelement des ersten Gehäuseelement-Typs geschlossen ausgeführt sein und beispielsweise umlaufende Dichtungen aufweisen, die zwischen Gehäuseelement und Trägerelement angeordnet sind. Die zweite Schutzart kann beispielsweise IP 31 sein.

Gemäß einer Ausführungsform bildet das Gehäuseelement des ersten Gehäuseelement-Typs, insbesondere in Verbindung mit dem Trägerelement, ein erstes Volumen und das Gehäuseelement des zweiten Gehäuseelement-Typs bildet, insbesondere in Verbindung mit dem Trägerelement, ein zweites, von dem ersten Volumen verschiedenes Volumen.

Gemäß einer Ausführungsform weist ein dritter Typ von Frequenzumrichtern der Frequenzumrichter-Baureihe als Gleichteile zum ersten Typ von Frequenzumrichtern und zum zweiten Typ von Frequenzumrichtern ebenfalls die typgleiche Leistungselektronik und das typgleiche Trägerelement auf. Insofern gibt es zwischen dem ersten Typ, dem zweiten Typ und dem dritten Typ keine Unterschiede. Der dritte Typ von Frequenzumrichtern der Frequenzumrichter-Baureihe unterscheidet sich vom ersten Typ bzw. zweiten Typ von Frequenzumrichtern der Frequenzumrichter-Baureihe durch sein Gehäuseelement eines dritten Gehäuseelement-Typs, das in Verbindung mit dem Trägerelement ein Gehäuse für die Leistungselektronik bildet.

Gemäß einer Ausführungsform ist das Gehäuseelement des ersten Gehäuseelement-Typs derart ausgebildet, dass der Frequenzumrichter des ersten Typs eine erste Schutzart aufweist, beispielsweise IP 66. Das Gehäuseelement des zweiten Gehäuseelement-Typs ist derart ausgebildet, dass der Frequenzumrichter des zweiten Typs eine zweite, von der ersten Schutzart verschiedene Schutzart aufweist, beispielswiese IP 31. Das Gehäuseelement des dritten Gehäuseelement-Typs bildet ein Volumen, das von einem Volumen verschieden ist, das der erste Gehäuseelement-Typ bildet, und/oder das der zweite Gehäuseelement-Typ bildet.

Gemäß einer Ausführungsform weisen der erste Typ, der zweite Typ und der dritte Typ von Frequenzumrichtern der Frequenzumrichter-Baureihe ein abnehmbares Deckelelement auf, mittels dem ein Anschlussraum des Frequenzumrichters öffenbar und wieder verschließbar ist. Im Anschlussraum können typunabhängig Anschlüsse der jeweiligen Frequenzumrichter angeordnet sein, über die der jeweilige Frequenzumrichter beispielsweise mit einem Drehstrommotor, Sensoren, Gebern, einem Zwischenkreis, einem Drehstromnetz usw. elektrisch verbunden werden kann. Der erste Typ und der zweite Typ von Frequenzumrichtern der Frequenzumrichter-Baureihe können ein identisches Deckelelement aufweisen.

Zwischen dem Trägerelement und einem Gehäuseelement eines Typs oder aller Typen ist eine formschlüssige Verbindung vorhanden. Je nach notwendiger Schutzart ist im Bereich der formschlüssigen Verbindung eine Dichtung vorgesehen.

Gemäß einer Ausführungsform ist das Deckelelement keilförmig ausgebildet, um bei abgenommenem bzw. geöffnetem Deckelelement einen möglichst ungehinderten Zugang zu dem Anschlussraum zu ermöglichen.

Gemäß einer Ausführungsform weist nur ein Typ, insbesondere der dritte Typ, von Frequenzumrichtern der Frequenzumrichter-Baureihe einen Netztrennschalter auf, der schaltzustandsabhängig den entsprechenden Typ von Frequenzumrichter mit einem Drehstromnetz verbindet bzw. von diesem trennt.

Gemäß einer Ausführungsform bildet das Trägerelement einen Kühlkörper, insbesondere aus Metall, insbesondere in Form eines Gusskörpers. Der Kühlkörper kann auf seiner vom Gehäuseelement abgewandten Seite Kühlrippen aufweisen. Der Kühlkörper dient insbesondere zur Kühlung der Leistungselektronik und ist mit dieser bevorzugt wärmeleitend verbunden.

Gemäß einer Ausführungsform weist das Trägerelement Befestigungsmittel auf, mittels derer ein jeweiliger Frequenzumrichter mechanisch lösbar an einem vorgesehenen Anbringungsort befestigbar ist, beispielsweise auf einer Schiene in einem Schaltschrank oder innerhalb einer Anlage oder an einer Gebäudewand.

Gemäß einer Ausführungsform weisen der erste Typ, der zweite Typ und der dritte Typ von Frequenzumrichtern der Frequenzumrichter-Baureihe eine wannenförmige Aufnahmemulde und eine in der Aufnahmemulde angeordnete Schnittstelle auf, wobei in der Aufnahmemulde ein Frequenzumrichter-externes Steuergerät einsetzbar ist, das über die Schnittstelle mit dem jeweiligen Frequenzumrichter zum Datenaustausch koppelbar ist. Das Steuergerät kann beispielsweise ein Parametriergerät, ein WLAN-Modul usw. sein.

Die Erfindung wird nachfolgend unter Bezugnahme auf die Zeichnungen detailliert beschrieben. Hierbei zeigt:
- Fig. 1: eine perspektivische Darstellung eines Frequenzumrichters eines ersten Typs einer Frequenzumrichter-Baureihe,
- Fig. 2: eine perspektivische Darstellung eines Frequenzumrichters eines zweiten Typs einer Frequenzumrichter-Baureihe,
- Fig. 3: eine perspektivische Darstellung eines Frequenzumrichters eines dritten Typs einer Frequenzumrichter-Baureihe,
- Fig. 4: eine perspektivische Darstellung eines Frequenzumrichters des ersten, zweiten oder dritten Typs bei entferntem Gehäuseelement, wobei auf einer Platine des Frequenzumrichters ein Safety-Modul gesteckt ist, und
- Fig. 5: eine perspektivische Darstellung des Frequenzumrichters von Fig. 4 ohne gestecktes Safety-Modul.

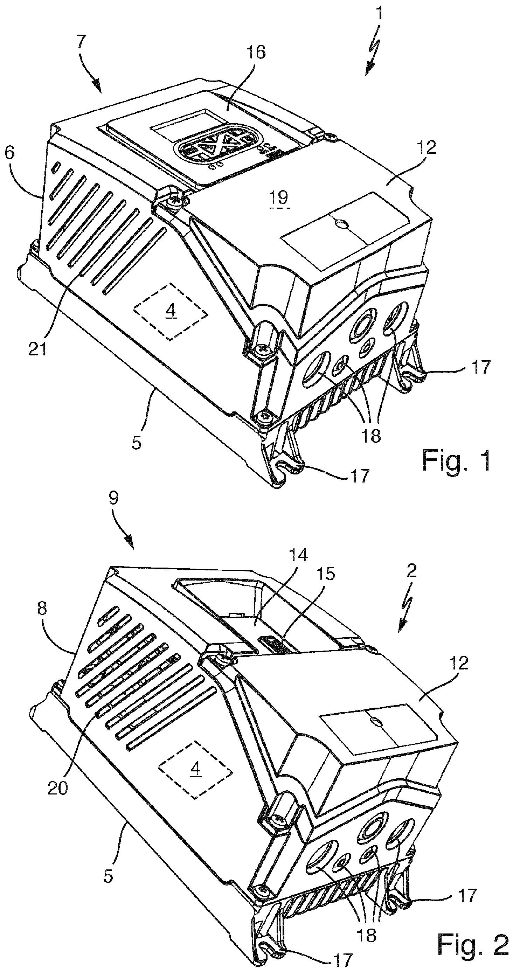

Fig. 1 zeigt eine perspektivische Darstellung eines Frequenzumrichters 1 eines ersten Typs einer Frequenzumrichter-Baureihe.

Der erste Typ von Frequenzumrichter der Frequenzumrichter-Baureihe setzt sich zusammen aus einer Leistungselektronik 4, beispielsweise einem dreiphasigen Wechselrichter, einem Trägerelement 5 aus Metall, das gleichzeitig einen Kühlkörper bildet, und einem Gehäuseelement 6 eines ersten Gehäuseelement-Typs, das in Verbindung mit dem Trägerelement 5 ein Gehäuse 7 für die Leistungselektronik 4 bildet.

Der Frequenzumrichter 1 weist eine Schutzart gemäß IP 66 auf.

Der Frequenzumrichtern 1 weist ein abnehmbares keilförmiges Deckelelement 12 auf, mittels dem ein Anschlussraum 19 des Frequenzumrichters 1 verschließbar ist. Wenn das Deckelelement 12 abgenommen ist, sind Anschlüsse des Frequenzumrichters 1 zugänglich, so dass beispielsweise Kabel, die über Kabelzuführungsöffnungen 18 in den Anschlussraum 19 geführt sind, an die Anschlüsse angeschlossen werden können.

Das Trägerelement 5 weist Befestigungsmittel 17 auf, mittels derer der Frequenzumrichter 1 mechanisch lösbar an einem vorgesehenen Anbringungsort befestigbar ist.

In eine in dem Gehäuseelement 6 gebildete Aufnahmemulde 14, in der eine Schnittstelle 15 des Frequenzumrichters 1 angeordnet ist, ist ein externes Steuergerät 16 in Form einer Parametriervorrichtung eingesetzt, das über die Schnittstelle 15 mit dem Frequenzumrichter 1 zum Datenaustausch gekoppelt ist, siehe auch Fig. 2.

Fig. 2 zeigt eine perspektivische Darstellung eines Frequenzumrichters 2 eines zweiten Typs der Frequenzumrichter-Baureihe, aus Beschreibungsgründen ohne ein in die Aufnahmemulde 14 eingesetztes externes Steuergerät 16.

Der Frequenzumrichter 2 des zweiten Typs unterscheidet sich bevorzugt von dem Frequenzumrichter 1 des ersten Typs nur durch sein Gehäuseelement 8 bzw. Gehäuse 9, das streifenförmige Öffnungen 20 aufweist, wohingegen das Gehäuseelement 6 geschlossene Lamellen 21 aufweist. Eine jeweilige Längserstreckung der streifenförmigen Öffnungen 10 bzw. der Lamellen 21 in der vorgesehenen Einbauausrichtung des Frequenzumrichters 1 bzw. 2 bildet einen Winkel von ca. 25 Grad zur Waagerechten.

Der Frequenzumrichters 2 des zweiten Typs weist eine Schutzart gemäß IP 31 auf, wohingegen der Frequenzumrichters 1 des ersten Typs eine Schutzart gemäß IP 66 aufweist.

Bei dem Frequenzumrichter 1 des ersten Typs mit Schutzart gemäß IP 66 können zum Erzielen der höheren Schutzart zusätzlich noch Dichtungen zwischen dem Gehäuseelement 6 und dem Trägerelement 5 vorgesehen sein.

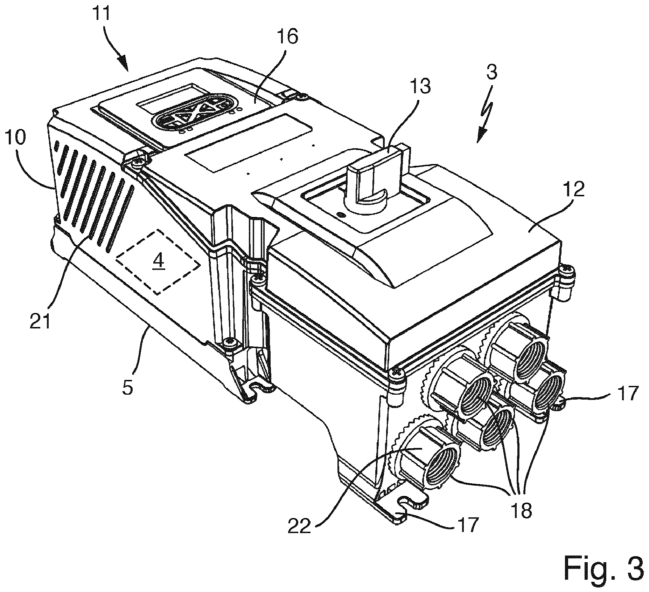

Fig. 3 zeigt eine perspektivische Darstellung eines Frequenzumrichters 3 eines dritten Typs der Frequenzumrichter-Baureihe.

Der Frequenzumrichter 3 des dritten Typs unterscheidet sich von den Frequenzumrichtern 1 und 2 des ersten bzw. zweiten Typs unter anderem durch sein Gehäuseelement 10 bzw. sein Gehäuse 11, das ein anderes Volumen aufweist als die gleichvolumigen Gehäuseelemente 6 und 8.

Der Frequenzumrichter 3 weist anders als die Frequenzumrichter 1 und 2 einen Netztrennschalter 13 zur Netztrennung auf. Der Frequenzumrichter 3 kann eine Schutzart gemäß IP 66 aufweisen.

Zusätzlich zu den Kabelzuführungsöffnungen 18 sind bevorzugt weitere Öffnungen aus den Gehäuseelementen 6, 8 und 10 ausbrechbar, um weitere Kabeltypen ins Gehäuse führen zu können. Standardmäßig können beispielsweise nur Netz- und Motoranschluss-Öffnungen vorhanden sein.

Die Gehäuseelemente 6, 8, 10 sind beispielsweise mittels Schrauben am Trägerelement 5 lösbar befestigt.

Das Deckelelement 12 kann ebenfalls mittels Schrauben an den Gehäuseelementen 6, 8, 10 lösbar befestigt sein.

Die erfindungsgemäße Frequenzumrichter-Baureihe weist eine hohe Gleichteileübereinstimmung mit identischer Leistungselektronik und Trägerelement auf. Unterschiede bestehen im Kern lediglich in den verschiedenen Gehäuseelementen, mittels derer die Frequenzumrichter ausdifferenziert bzw. typisiert sind. Dies ermöglicht eine kostengünstige Fertigung und Lagerhaltung bei gleichzeitig hoher Flexibilität.

Bezug nehmend auf Fig. 3 können die Kabelzuführungsöffnungen 18 mit zugehörigen Verschlusstopfen 22 verschlossen werden, um eine notwendige Fluid-Dichtigkeit bzw. Schutzart zu erzielen.

Die Verschlusstopfen 22 können auch in Verbindung mit der in Fig. 1 gezeigten Ausführungsform verwendet werden.

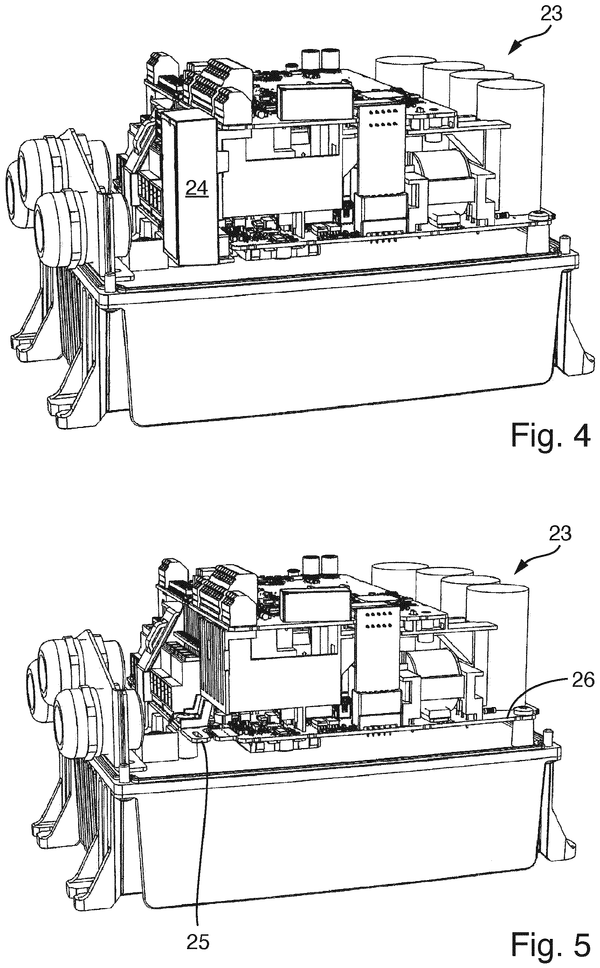

Fig. 4 zeigt eine perspektivische Darstellung eines Frequenzumrichters 23 des ersten, zweiten oder dritten Typs bei entferntem Gehäuseelement 6, 8 bzw. 10. Der Frequenzumrichter 23 weist eine Platine 26 auf, auf der ein Safety-Modul 24 gesteckt ist. Das gesteckte Safety-Modul 24 bewirkt, dass der Frequenzumrichter 23 bestimmte Voraussetzungen der funktionalen Sicherheit erfüllt.

Fig. 5 zeigt eine perspektivische Darstellung des Frequenzumrichters 23 von Fig. 4 ohne gestecktes Safety-Modul 24, wodurch sich das Verhalten des Frequenzumrichters 23 im Hinblick auf die funktionale Sicherheit verändert.

Wie in Fig. 5 gezeigt, weist die Platine 26 Steckzungen 25 auf, auf die das Safety-Modul 24, wie in Fig. 4 gezeigt, aufsteckbar ist.

Auf der Platine 26 kann die Leistungselektronik 4 angeordnet sein.

## Patentansprüche

1. Frequenzumrichter-Baureihe mit unterschiedlichen Typen von Frequenzumrichtern (1, 2, 3),
- wobei ein erster Typ von Frequenzumrichtern (1) der Frequenzumrichter-Baureihe zusammengesetzt ist aus:
- einer Leistungselektronik (4),
- einem Trägerelement (5) und
- einem Gehäuseelement (6) eines ersten Gehäuseelement-Typs, das in Verbindung mit dem Trägerelement (5) ein Gehäuse (7) für die Leistungselektronik (4) bildet, und
- wobei ein zweiter Typ von Frequenzumrichtern (2) der Frequenzumrichter-Baureihe zusammengesetzt ist aus:
- der Leistungselektronik (4),
- dem Trägerelement (5) und
- einem Gehäuseelement (8) eines zweiten Gehäuseelement-Typs, das in Verbindung mit dem Trägerelement (5) ein Gehäuse (9) für die Leistungselektronik (4) bildet,
**dadurch gekennzeichnet, dass**
- das Gehäuseelement (6) des ersten Gehäuseelement-Typs derart ausgebildet ist, dass der Frequenzumrichter (1) des ersten Typs eine erste Schutzart aufweist,
- das Gehäuseelement (8) des zweiten Gehäuseelement-Typs derart ausgebildet ist, dass der Frequenzumrichter (2) des zweiten Typs eine zweite, von der ersten Schutzart verschiedene Schutzart aufweist, und
- zwischen dem Trägerelement (5) und dem Gehäuseelement (6) des ersten Gehäuseelement-Typs und zwischen dem Trägerelement (5) und dem Gehäuseelement (8) des zweiten Gehäuseelement-Typs jeweils eine formschlüssige Verbindung vorhanden ist,
- wobei je nach notwendiger Schutzart im Bereich der formschlüssigen Verbindung eine Dichtung vorgesehen ist.

2. Frequenzumrichter-Baureihe nach Anspruch 1, **dadurch gekennzeichnet, dass**
- die erste Schutzart IP 66 ist und
- die zweite Schutzart IP 31 ist.

3. Frequenzumrichter-Baureihe nach Anspruch 1, **dadurch gekennzeichnet, dass**
- das Gehäuseelement (6) des ersten Gehäuseelement-Typs ein erstes Volumen bildet und
- das Gehäuseelement (8) des zweiten Gehäuseelement-Typs ein zweites, von dem ersten Volumen verschiedenes Volumen bildet.

4. Frequenzumrichter-Baureihe nach Anspruch 1, **dadurch gekennzeichnet, dass**
- ein dritter Typ von Frequenzumrichtern (3) der Frequenzumrichter-Baureihe zusammengesetzt ist aus:
- der Leistungselektronik (4),
- dem Trägerelement (5) und
- einem Gehäuseelement (10) eines dritten Gehäuseelement-Typs, das in Verbindung mit dem Trägerelement (5) ein Gehäuse (11) für die Leistungselektronik (4) bildet.

5. Frequenzumrichter-Baureihe nach Anspruch 4, **dadurch gekennzeichnet, dass**
- das Gehäuseelement (6) des ersten Gehäuseelement-Typs derart ausgebildet ist, dass der Frequenzumrichter (1) des ersten Typs eine erste Schutzart aufweist,
- das Gehäuseelement (8) des zweiten Gehäuseelement-Typs derart ausgebildet ist, dass der Frequenzumrichter (2) des zweiten Typs eine zweite, von der ersten Schutzart verschiedene Schutzart aufweist, und
- das Gehäuseelement (10) des dritten Gehäuseelement-Typs ein Volumen bildet, das von einem Volumen, das der erste Gehäuseelement-Typ bildet, und/oder von einem von einem Volumen, das der zweite Gehäuseelement-Typ bildet, verschieden ist.

6. Frequenzumrichter-Baureihe nach einem der vorhergehenden Ansprüche, **dadurch gekennzeichnet, dass**
- alle Typen von Frequenzumrichtern (1, 2, 3) der Frequenzumrichter-Baureihe ein Deckelelement (12) aufweisen, mittels dem ein Anschlussraum (19) des Frequenzumrichters verschließbar ist.

7. Frequenzumrichter-Baureihe nach Anspruch 6, **dadurch gekennzeichnet, dass**
- das Deckelelement (12) keilförmig ausgebildet ist.

8. Frequenzumrichter-Baureihe nach einem der vorhergehenden Ansprüche, **dadurch gekennzeichnet, dass**
- ein Typ von Frequenzumrichtern (1, 2, 3) der Frequenzumrichter-Baureihe einen Netztrennschalter (13) aufweist.

9. Frequenzumrichter-Baureihe nach einem der vorhergehenden Ansprüche, **dadurch gekennzeichnet, dass**
- das Trägerelement (5) einen Kühlkörper bildet.

10. Frequenzumrichter-Baureihe nach einem der vorhergehenden Ansprüche, **dadurch gekennzeichnet, dass**
- das Trägerelement (5) Befestigungsmittel (17) aufweist, mittels derer ein jeweiliger Frequenzumrichter (1, 2, 3) mechanisch lösbar an einem vorgesehenen Anbringungsort befestigbar ist.

11. Frequenzumrichter-Baureihe nach einem der vorhergehenden Ansprüche, **dadurch gekennzeichnet, dass**
- alle Typen von Frequenzumrichtern (1, 2, 3) der Frequenzumrichter-Baureihe eine Aufnahmemulde (14) und eine in der Aufnahmemulde (14) angeordnete Schnittstelle (15) aufweisen, wobei in der Aufnahmemulde (14) ein externes Steuergerät (16) einsetzbar ist, das über die Schnittstelle (15) mit dem jeweiligen Frequenzumrichter (1, 2, 3) zum Datenaustausch koppelbar ist.

## Claims

1. Frequency converter class comprising different types of frequency converters (1, 2, 3),
- wherein a first type of frequency converters (1) in the frequency converter class is composed of:
- power electronics (4),
- a carrier element (5) and
- a housing element (6) of a first housing element type which, in combination with the carrier element (5), forms a housing (7) for the power electronics (4), and
- wherein a second type of frequency converters (2) in the frequency converter class is composed of:
- the power electronics (4),
- the carrier element (5) and
- a housing element (8) of a second housing element type which, in combination with the carrier element (5), forms a housing (9) for the power electronics (4),
**characterized in that**
- the housing element (6) of the first housing element type is designed such that the frequency converter (1) of the first type has a first protection rating,
- the housing element (8) of the second housing element type is designed such that the frequency converter (2) of the second type has a second protection rating, which is different from the first protection rating, and
- there is a form-fit connection between the carrier element (5) and the housing element (6) of the first housing element type and between the carrier element (5) and the housing element (8) of the second housing element type,
- wherein there is provision for a seal in the region of the form-fit connection, depending on the protection rating required.

2. Frequency converter class according to Claim 1, **characterized in that**
- the first protection rating is IP 66 and
- the second protection rating is IP 31.

3. Frequency converter class according to Claim 1, **characterized in that**
- the housing element (6) of the first housing element type forms a first volume and
- the housing element (8) of the second housing element type forms a second volume, which is different from the first volume.

4. Frequency converter class according to Claim 1, **characterized in that**
- a third type of frequency converters (3) in the frequency converter class is composed of:
- the power electronics (4),
- the carrier element (5) and
- a housing element (10) of a third housing element type which, in combination with the carrier element (5), forms a housing (11) for the power electronics (4).

5. Frequency converter class according to Claim 4, **characterized in that**
- the housing element (6) of the first housing element type is designed such that the frequency converter (1) of the first type has a first protection rating,
- the housing element (8) of the second housing element type is designed such that the frequency converter (2) of the second type has a second protection rating, which is different from the first protection rating, and
- the housing element (10) of the third housing element type forms a volume which is different from a volume formed by the first housing element type and/or from a volume formed by the second housing element type.

6. Frequency converter class according to one of the preceding claims, **characterized in that**
- all types of frequency converters (1, 2, 3) in the frequency converter class comprise a cover element (12) by means of which a connection compartment (19) of the frequency converter can be closed.

7. Frequency converter class according to Claim 6, **characterized in that**
- the cover element (12) is wedge-shaped.

8. Frequency converter class according to one of the preceding claims, **characterized in that**
- one type of frequency converters (1, 2, 3) in the frequency converter class comprises a mains disconnector (13).

9. Frequency converter class according to one of the preceding claims, **characterized in that**
- the carrier element (5) forms a heat sink.

10. Frequency converter class according to one of the preceding claims, **characterized in that**
- the carrier element (5) comprises fastening means (17) by means of which a respective frequency converter (1, 2, 3) can be fastened to an intended attachment site in a mechanically detachable manner.

11. Frequency converter class according to one of the preceding claims, **characterized in that**
- all types of frequency converters (1, 2, 3) in the frequency converter class comprise a location well (14) and an interface (15) arranged in the location well (14), wherein an external control device (16) can be inserted in the location well (14), and can be coupled to the respective frequency converter (1, 2, 3) via the interface (15) for the purposes of data interchange.

## Revendications

1. Gamme de variateurs de fréquence comprenant différents types de variateurs de fréquence (1, 2, 3),
- un premier type de variateurs de fréquence (1) de la gamme de variateurs de fréquence étant composé de :
- une électronique de puissance (4),
- un élément porteur (5) et
- un élément de boîtier (6) d'un premier type d'élément de boîtier, qui forme, en association avec l'élément porteur (5), un boîtier (7) pour l'électronique de puissance (4), et
- un deuxième type de variateurs de fréquence (2) de la gamme de variateurs de fréquence étant composé de :
- l'électronique de puissance (4),
- l'élément porteur (5) et
- un élément de boîtier (8) d'un deuxième type d'élément de boîtier, qui forme, en association avec l'élément porteur (5), un boîtier (9) pour l'électronique de puissance (4),
**caractérisée en ce que**
- l'élément de boîtier (6) du premier type d'élément de boîtier est configuré de telle sorte que le variateur de fréquence (1) du premier type présente un premier degré de protection,
- l'élément de boîtier (8) du deuxième type d'élément de boîtier est configuré de telle sorte que le variateur de fréquence (2) du deuxième type présente un deuxième degré de protection, différent du premier degré de protection, et
- il existe respectivement une liaison par complémentarité de formes entre l'élément porteur (5) et l'élément de boîtier (6) du premier type d'élément de boîtier et entre l'élément porteur (5) et l'élément de boîtier (8) du deuxième type d'élément de boîtier,
- un joint d'étanchéité étant présent dans la zone de la liaison par complémentarité de formes, en fonction du degré de protection nécessaire.

2. Gamme de variateurs de fréquence selon la revendication 1, **caractérisée en ce que**
- le premier degré de protection est IP 66 et
- le deuxième degré de protection est IP 31.

3. Gamme de variateurs de fréquence selon la revendication 1, **caractérisée en ce que**
- l'élément de boîtier (6) du premier type d'élément de boîtier forme un premier volume, et
- l'élément de boîtier (8) du deuxième type d'élément de boîtier forme un deuxième volume, différent du premier volume.

4. Gamme de variateurs de fréquence selon la revendication 1, **caractérisée en ce que**
- un troisième type de variateurs de fréquence (3) de la gamme de variateurs de fréquence est composé de :
- l'électronique de puissance (4),
- l'élément porteur (5) et
- un élément de boîtier (10) d'un troisième type d'élément de boîtier, qui forme, en association avec l'élément porteur (5), un boîtier (11) pour l'électronique de puissance (4).

5. Gamme de variateurs de fréquence selon la revendication 4, **caractérisée en ce que**
- l'élément de boîtier (6) du premier type d'élément de boîtier est configuré de telle sorte que le variateur de fréquence (1) du premier type présente un premier degré de protection,
- l'élément de boîtier (8) du deuxième type d'élément de boîtier est configuré de telle sorte que le variateur de fréquence (2) du deuxième type présente un deuxième degré de protection, différent du premier degré de protection, et
- l'élément de boîtier (10) du troisième type d'élément de boîtier forme un volume qui est différent d'un volume que forme le premier type d'élément de boîtier et/ou d'un volume que forme le deuxième type d'élément de boîtier.

6. Gamme de variateurs de fréquence selon l'une des revendications précédentes, **caractérisée en ce que**
- tous les types de variateurs de fréquence (1, 2, 3) de la gamme de variateurs de fréquence possèdent un élément de couvercle (12) au moyen duquel un espace de raccordement (19) du variateur de fréquence peut être fermé.

7. Gamme de variateurs de fréquence selon la revendication 6, **caractérisée en ce que**
- l'élément de couvercle (12) est réalisé en forme de coin.

8. Gamme de variateurs de fréquence selon l'une des revendications précédentes, **caractérisée en ce que**
- un type de variateurs de fréquence (1, 2, 3) de la gamme de variateurs de fréquence possède un sectionneur de réseau (13).

9. Gamme de variateurs de fréquence selon l'une des revendications précédentes, **caractérisée en ce que**
- l'élément porteur (5) forme un dissipateur thermique.

10. Gamme de variateurs de fréquence selon l'une des revendications précédentes, **caractérisée en ce que**
- l'élément porteur (5) possède des moyens de fixation (17) au moyen desquels un variateur de fréquence (1, 2, 3) respectif peut être fixé de manière mécaniquement amovible à un emplacement de montage prévu.

11. Gamme de variateurs de fréquence selon l'une des revendications précédentes, **caractérisée en ce que**
- tous les types de variateurs de fréquence (1, 2, 3) de la gamme de variateurs de fréquence possèdent une cavité d'accueil (14) et une interface (15) disposée dans la cavité d'accueil (14), un contrôleur externe (16) pouvant être inséré dans la cavité d'accueil (14), lequel peut être couplé au variateur de fréquence respectif (1, 2, 3) par le biais de l'interface (15) pour l'échange de données.
